# EUROPÄISCHE PATENTSCHRIFT

(11) **EP 1 444 785 B1**
(45) Veröffentlichungstag und Bekanntmachung des Hinweises auf die Patenterteilung: **11.01.2006**
(21) Anmeldenummer: 02772035.8
(22) Anmeldetag: 29.08.2002
(51) Int. Cl.: H03M 1/82, H03K 7/08

(54) **DIGITAL/ANALOG-UMSETZER-SCHALTUNG MIT EINER VORRICHTUNG ZUR KOMPENSATION VON NICHTLINEAREN VERZERRUNGEN**
DIGITAL/ANALOG CONVERTER CIRCUIT WITH A DEVICE FOR COMPENSATING NONLINEAR DISTORTIONS
CIRCUIT DE CONVERTISSEUR NUMERIQUE/ANALOGIQUE COMPORTANT UN DISPOSITIF DE COMPENSATION DE DISTORSIONS NON LINEAIRES

(30) Priorität: 12.11.2001 DE 10155426
(43) Veröffentlichungstag der Anmeldung: 11.08.2004
(73) Patentinhaber: Infineon Technologies AG, 81669 München (DE)
(72) Erfinder: KRANZ, Christian, 40885 Ratingen Lintorf (DE)
(74) Vertreter: Lange, Thomas
(86) Internationale Anmeldenummer: PCT/DE2002/003174
(87) Internationale Veröffentlichungsnummer: WO 2003/043196

(56) Entgegenhaltungen:
- EP-A- 0 982 865
- WO-A-95/06980
- WO-A-97/37433
- US-B1- 6 232 899
- GOLDBERG J M ET AL: "PSEUDO-NATURAL PULSE WIDTH MODULATION FOR HIGH ACCURACY DIGITAL-TO-ANALOGUE CONVERSION" ELECTRONICS LETTERS, IEE STEVENAGE, GB, Bd. 27, Nr. 16, 1. August 1991 (1991-08-01), Seiten 1491-1492, XP000213889 ISSN: 0013-5194

## Beschreibung

Die Erfindung betrifft eine Digital/Analog-Umsetzer-Schaltung, mittels welcher digitale PCM-Signale verzerrungsfrei in analoge Signale umgewandelt werden können.

In vielen technischen Systemen werden digitale Signale mittels Pulsweitenmodulation in analoge Signale umgewandelt. Beispiele für derartige Systeme sind Motorensteuerungen, Kalibrierungsschaltungen, Schaltnetzteile, Gleichspannungswandler, digitale Verstärker und insbesondere digitale Audio-Verstärker.

Das digitale Signal liegt bei den genannten Systemen eingangsseitig in der Regel als PCM (pulse code modulated)-Signal vor und wird zunächst in ein digitales PWM (pulse width modulated)-Signal umgesetzt. Anschließend erfolgt eine Umsetzung des digitalen PWM-Signals in ein analoges Signal. Sowohl bei der PCM/PWM-Umsetzung als auch bei der Umwandlung des PWM-Signals in das analoge Signal können nichtlineare Verzerrungen auftreten. Die PCM/PWM-Umsetzung ist aufgrund der digitalen Signalverarbeitung allerdings prinzipiell verlustfrei durchführbar, d.h. aus dem PWM-Signal könnte durch eine invertierte Umsetzung das ursprüngliche PCM-Signal ohne Informationsverlust erzeugt werden. Demgegenüber treten bei der Umsetzung des digitalen PWM-Signals in das analoge Signal unvermeidlich nichtlineare Verzerrungen auf. Diese Verzerrungen werden hauptsächlich durch das "Gedächtnis" des Analog-Bereichs der betreffenden Schaltung verursacht. Die relativ langen Abklingzeiten des analogen "Gedächtnisses", welche üblicherweise über die Zeitspanne einer PWM-Periode hinausgehen, führen zu einer Überlagerung von ausklingenden Rechteckantworten aus der Vergangenheit mit der aktuellen Rechteckantwort. Da die zurückliegenden Rechteckantworten von der Pulsweite des digitalen PWM-Signals abhängen und diese wiederum von dem PCM-Signal, sind die Verzerrungen nichtlinear.

Derartige "Gedächtnis"-Eigenschaften einer analogen Schaltung sind systemimmanent und können nicht vollständig eliminiert werden. Daher werden Wege gesucht, die bei der Digital/Analog-Umsetzung auftretenden nichtlinearen Verzerrungen durch zusätzliche digitale oder analoge Schaltungen zu minimieren oder gar zu kompensieren.

In der internationalen Patentanmeldung WO 97/37433 A1 ist eine nach dem vorstehenden Prinzip arbeitende Digital/Analog-Umsetzer-Schaltung beschrieben, bei welcher im Signalweg vor der PCM/PWM-Umsetzerstufe ein nichtlineares Hammerstein-Filter angeordnet ist. Das Hammerstein-Filter stellt eine Vorkompensationsstufe dar, durch welche das PCM-Signal mit einer nichtlinearen Verzerrung beaufschlagt wird, die invers zu der bei der PCM/PWM-Umsetzung auftretenden nichtlinearen Verzerrung ist, sodass sich insgesamt ein verzerrungsfreies digitales PWM-Signal ergibt. Ein Nachteil dieser Digital/Analog-Umsetzer-Schaltung ist, dass sie ausschließlich für UPWM (uniform sampling pulse width modulated)-Signale ausgelegt ist. Bei UPWM-Signalen wird der Wert der Pulsweite stets zu Beginn der PWM-Periode festgelegt. PWM-Signale, deren Pulsweite während der PWM-Periode bestimmt wird, sogenannte PNPWM (pseudonatural pulse width modulation)-Signale, können mit der vorliegenden Schaltung nicht generiert werden.

In der internationalen Patentanmeldung WO 95/06980 A1 ist eine weitere Möglichkeit aufgezeigt, um die bei einer PCM/PWM-Umsetzung auftretenden Nichtlinearitäten zu kompensieren. Dazu hat eine Digital/Analog-Umsetzer-Schaltung Zugang zu einer in einem Festwertspeicher gespeicherten Tabelle. Mit Hilfe der in der Tabelle abgelegten Daten wird eine Kompensation der nichtlinearen Verzerrungen erzielt.

Ein relativ aufwendiger Algorithmus zur digitalen Kompensation von nichtlinearen Verzerrungen durch einen der PCM/PWM-Umsetzerstufe vorgeschalteten Noise-Shaper mit einem speziell angepassten digitalen Filter im Rückkopplungszweig ist in dem Artikel "New high accuracy pulse width modulation based digital-to-analogue convertor/power amplifier" von J. M. Goldberg und M. B. Sandler, erschienen in IEE Proc.-Circuits Devices Syst., Band 141, Nr. 4, 1994, Seiten 315-324, beschrieben.

Des Weiteren sind auch analoge Schaltungen bekannt, welche über Rückkopplungszweige Nichtlinearitäten minimieren. Beispielsweise befassen sich die Artikel "A New PWM Controller with One-Cycle Response" von K. M. Smith, Z. Lai und K. M. Smedley, erschienen in IEEE Transactions on Power Electronics, Band 14, Nr. 1, 1999, Seiten 142-150, und "A Novel Low-Power Low-Voltage Class D Amplifier with Feedback for Improving THD, Power Efficiency and Gain Linearity" von J. S. Chang, B. H. Gwee, Y. S. Lon und M. T. Tan, erschienen in ISACS 2001, Band 1, Seiten 635-638, mit derartigen analogen Rückkopplungsschaltungen. Nachteilig an Rückkopplungsschaltungen sind die durch sie verursachten Instabilitäten.

In der US-Patentschrift US 6,232,899 B1 ist eine Digital/Analog-Umsetzer-Schaltung gemäß dem Oberbegriff des Anspruchs 1 offenbart.

Aufgabe der Erfindung ist es, eine möglichst verzerrungsarme Digital/Analog-Umsetzer-Schaltung zu schaffen. Insbesondere sollen die durch den Analog-Bereich der Schaltung verursachten nichtlinearen Verzerrungen kompensiert werden. Ferner soll ein diese Eigenschaften aufweisendes Verfahren angegeben werden.

Die der Erfindung zugrunde liegende Aufgabenstellung wird durch die Merkmale der unabhängigen Patentansprüche 1 und 10 gelöst. Vorteilhafte Weiterbildungen und Ausgestaltungen der Erfindung sind in den Unteransprüchen angegeben.

Die erfindungsgemäße Digital/Analog-Umsetzer-Schaltung dient zur Umsetzung eines digitalen PCM-Eingangssignals in ein analoges Ausgangssignal. Dazu umfasst die Digital/Analog-Umsetzer-Schaltung im Signalweg eine Vorkompensationsstufe, eine der Vorkompensationsstufe nachgeschaltete PCM/PWM-Umsetzerstufe zur Erzeugung eines digitalen PWM-Signals aus dem digitalen, vorkompensierten PCM-Signal und eine wiederum nachgeschaltete Digital/Analog-Umsetzerstufe, an welcher ausgangsseitig das analoge Ausgangssignal abgreifbar ist. Die Übertragungsfunktion der Vorkompensationsstufe ist derart ausgelegt, dass das analoge Ausgangssignal im Wesentlichen proportional zu dem digitalen PCM-Eingangssignal ist. Ferner enthält die Vorkompensationsstufe eine weitere PCM/PWM-Umsetzerstufe, eine Überabtaststufe, ein digitales Filter und eine Dezimationsstufe. Die vorstehend aufgeführten Bauelemente der Vorkompensationsstufe sind dabei im Signalweg in der genannten Reihenfolge angeordnet. Bei dieser Ausgestaltung der Vorkompensationsstufe wird das digitale PCM-Eingangssignal zunächst in ein digitales PWM-Zwischensignal umgewandelt. Die Überabtaststufe erzeugt aus dem digitalen PWM-Zwischensignal ein digitales PCM-Zwischensignal, welches eine gegenüber dem digitalen PCM-Eingangssignal erhöhte Signalrate aufweist. Das digitale PCM-Zwischensignal wird danach dem digitalen Filter zugeführt. Die Dezimationsstufe bewirkt, dass die Signalrate des gefilterten PCM-Zwischensignals wieder reduziert wird.

Bei der erfindungsgemäßen Digital/Analog-Umsetzer-Schaltung wird das digitale PCM-Eingangssignal beim Durchlaufen der Vorkompensationsstufe derart verzerrt, dass die nichtlineare Verzerrung, die bei den nachfolgenden PCM/PWM- und Digital/Analog-Umsetzungen auftreten, im analogen Ausgangssignal kompensiert werden. Daraus ergibt sich ein zu dem digitalen PCM-Eingangssignal proportionales analoges Ausgangssignal. Ein Vorteil der erfindungsgemäßen Vorkompensation ist, dass die nichtlinearen Verzerrungen, die durch den Analog-Bereich der Schaltung verursacht werden, bei der Vorkompensation berücksichtigt werden. Durch die erhöhte Signalrate kann der Einfluss der analogen Schaltungsbereiche approximiert werden und damit insgesamt eliminiert werden.

Mit der erfindungsgemäßen Digital/Analog-Umsetzer-Schaltung lassen sich alle Arten von pulsweitenmodulierten Signalen erzeugen; sie ist nicht wie die in der Druckschrift WO 97/37433 A1 beschriebene Schaltung auf UPWM-Signale beschränkt. Ein weiterer Vorteil gegenüber der genannten Schaltung ist die erfindungsgemäße Verwendung eines einfachen, beispielsweise linearen digitalen Filters anstelle eines aufwändigen nichtlinearen Hammerstein-Filters.

Ferner entfällt bei der erfindungsgemäßen Digital/Analog-Umsetzer-Schaltung die Notwendigkeit einer Rückkopplungsschleife, wie sie bei vielen herkömmlichen Digital/Analog-Umsetzer-Schaltungen notwendig ist. Die Einsparung einer Rückkoppelschleife führt zu einer größeren Stabilität der erfindungsgemäßen Digital/Analog-Umsetzer-Schaltung.

Vorteilhafterweise arbeitet die Vorkompensationsstufe zumindest teilweise mit einer höheren Signalrate als der Signalrate, die das digitale PCM-Eingangssignal aufweist. Die höhere Signalrate ermöglicht es, die analogen Schaltungsbereiche in Echtzeit zu simulieren und dadurch die durch die analogen Schaltungsbereiche erzeugten nichtlinearen Verzerrungen zu ermitteln. Das digitale PCM-Eingangssignal kann anschließend mit den inversen Verzerrungen beaufschlagt werden, um somit eine Kompensation der Verzerrungen zu erreichen. Im Unterschied dazu findet bei herkömmlichen Digital/Analog-Umsetzer-Schaltungen, die teilweise auch eine Vorkompensationsstufe aufweisen, eine derartige Erhöhung der Signalrate nicht statt. Vielmehr wird bei diesen Schaltungen die Signalrate des PCM-Eingangssignals beibehalten. Um die nichtlinearen Verzerrungen, die bei der PCM/PWM-Umsetzung auftreten, dennoch vorausberechnen zu können, werden sehr aufwendige Schaltungen benötigt.

Gemäß einer besonders vorteilhaften Ausgestaltung der Erfindung ist die Übertragungsfunktion des digitalen Filters derart einstellbar oder derart eingestellt, dass auftretende nichtlineare Verzerrungen durch inverse Verzerrungen kompensiert werden. Es ist denkbar, dass dazu die Filterkoeffizienten herstellerseitig voreingestellt werden und auf die analoge Umgebung der Digital/Analog-Umsetzer-Schaltung angepasst werden. Alternativ könnte vorgesehen sein, dass die Filterkoeffizienten von dem Anwender der Digital/Analog-Umsetzer-Schaltung eingestellt werden. Dieses würde einen Abgleich der Schaltung im endgültigen Produkt ermöglichen. Bei einem Einsatz in einem Audio-Verstärker könnten beispielsweise die verwendeten Lautsprecher bei diesem Abgleich berücksichtigt werden.

Es ist ebenfalls möglich, die Digital/Analog-Umsetzer-Schaltung für einen universellen Einsatz auszulegen. Dazu wird für die Übertragungsfunktion des digitalen Filters vorteilhafterweise eine Tiefpass-Funktion gewählt, welche bei der Verwendung eines zusätzlichen analogen Filters auch mit diesem abgestimmt sein kann. Durch diese Maßnahme lassen sich die auftretenden Nichtlinearitäten weitgehend kompensieren, ohne dass dabei die exakte analoge schaltungstechnische Umgebung der Digital/Analog-Umsetzer-Schaltung in Betracht gezogen werden muss.

Ferner ist es von Vorteil, der Vorkompensationsstufe einen Noise-Shaper vor- und/oder nachzuschalten. Der Noise-Shaper reduziert das Quantisierungsrauschen in einem bestimmten Frequenzband, beispielsweise dem Audio-Frequenzband.

Das analoge Ausgangssignal kann vorteilhafterweise mittels eines analogen Filters gefiltert werden. Diese Maßnahme ermöglicht es, das pulsförmige analoge Ausgangssignal in eine gewünschte Form zu bringen.

Mögliche Ausgestaltungen für das digitale Filter stellen beispielsweise rekursive Wellen-Digital-Filter oder FIR (finite impluse response)-Filter dar. Die Digital/Analog-Umsetzerstufe lässt sich zum Beispiel als Leistungsschalter realisieren. impulse response)-Filter dar. Die Digital/Analog-Umsetzerstufe lässt sich zum Beispiel als Leistungsschalter realisieren.

Die erfindungsgemäße Digital/Analog-Umsetzer-Schaltung kann besonders vorteilhaft in Audio-Verstärker, insbesondere in Audio-Class-D-Verstärker, integriert werden.

Bei dem erfindungsgemäßen Verfahren wird ein digitales PCM-Eingangssignal zunächst vorkompensiert. Das digitale, vorkompensierte PCM-Signal wird in ein digitales PWM-Signal umgesetzt. Anschließend wird das digitale PWM-Signal in ein analoges Ausgangssignal umgewandelt. Bei diesem Verfahren bewirkt die Vorkompensation, dass das analoge Ausgangssignal im Wesentlichen proportional zu dem digitalen PCM-Eingangssignal ist. Dabei werden bei der Vorkompensation des digitalen PCM-Eingangssignals folgende Schritte durchgeführt: Zunächst wird das digitale PCM-Eingangssignal in ein digitales PWM-Zwischensignal umgesetzt. Anschließend wird ein digitales PCM-Zwischensignal durch Überabtasten des digitalen PWM-Zwischensignals erzeugt. Schließlich wird das digitale PCM-. Zwischensignal mittels eines digitalen Filters gefiltert. Anschließend wird die Signalrate mittels einer Dezimationsstufe reduziert.

Das erfindungsgemäße Verfahren ermöglicht eine Umsetzung des digitalen PCM-Eingangssignals in das analoge Ausgangssignal, ohne dass das analoge Ausgangssignal mit nichtlinearen Verzerrungen behaftet ist, welche im analogen Schaltungsbereich durch verzögerte Signalabfälle erzeugt werden. Dieses wird durch die Vorkompensation erzielt, indem das digitale PCM-Eingangssignal beispielsweise mit einer Nichtlinearität beaufschlagt wird, welche sich invers zu der durch die anschließende Digital/Analog-Umsetzung verursachte Nichtlinearität verhält. Durch die erhöhte Signalrate kann der Einfluss der analogen Schaltungsbereiche approximiert werden und damit insgesamt eliminiert werden.

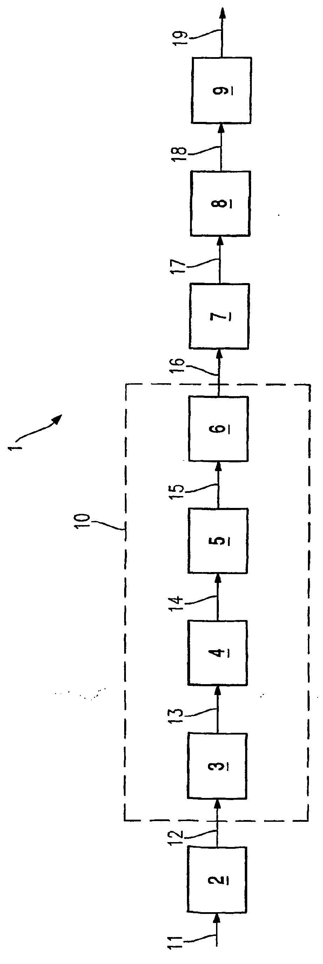

Die Erfindung wird nachfolgend in beispielhafter Weise unter Bezugnahme auf die Zeichnung näher erläutert. Die einzige Figur zeigt dabei ein schematisches Blockschaltbild eines Ausführungsbeispiels der erfindungsgemäßen Digital/Analog-Umsetzer-Schaltung.

In der Figur ist das Blockschaltbild einer Digital/Analog-Umsetzer-Schaltung 1 gezeigt, bei welcher im Signalweg ein Noise-Shaper 2, eine PCM/PWM-Umsetzerstufe 3, eine Überabtaststufe 4, ein digitales Filter 5, eine Dezimationsstufe 6, eine PCM/PWM-Umsetzerstufe 7, eine Digital/Analog-Umsetzerstufe 8 und ein analoges Filter 9 in der genannten Reihenfolge angeordnet sind. Die PCM/PWM-Umsetzerstufe 3, die Überabtaststufe 4, das digitale Filter 5 und die Dezimationsstufe 6 bilden gemeinsam eine Vorkompensationsstufe 10. Ein digitales PCM-Signal 11 wird eingangsseitig in den Noise-Shaper 2 eingespeist. Anschließend wird das aus dem Noise-Shaper 2 ausgegebene PCM-Signal 12 in ein digitales PWM-Signal 13 umgewandelt. Die Signalrate wird mittels der Überabtaststufe 4 erhöht. Das sich daraus ergebende PCM-Signal 14 wird mittels des digitalen Filters 5 gefiltert. Die Signalrate des gefilterten PCM-Signals 15 wird durch die Dezimationsstufe 6 wieder reduziert. Das digitale PCM-Signal 16 ist gegenüber dem digitalen PCM-Signal 11 aufgrund der digitalen Filterung nichtlinear verzerrt. Das digitale PCM-Signal 16 wird anschließend in ein digitales PWM-Signal 17 transformiert, und dieses wird in der Digital/Analog-Umsetzerstufe 8 in ein analoges Signal 18 umgewandelt. Das analoge Signal 18 wird abschließend gefiltert, sodass sich als Ausgangssignal der Digital/Analog-Umsetzer-Schaltung 1 ein gefiltertes analoges Signal 19 ergibt.

Die durch das digitale Filter 5 bewirkte nichtlineare Verzerrung des PCM-Signals 15 wird bis zu der Digital/Analog-Umsetzerstufe 8 von den jeweiligen digitalen Signalen mitgeführt. Durch die Digital/Analog-Umsetzung wird das resultierende analoge Signal 18 mit einer weiteren nichtlinearen Verzerrung beaufschlagt, welche beispielsweise von "Gedächtnis"-Eigenschaften der analogen Schaltungsbereiche herrührt. Die Übertragungsfunktion des digitalen Filters 5 wird so gewählt, dass die von ihm bewirkte nichtlineare Verzerrung sich invers zu der bei der Digital/Analog-Umsetzung auftretenden Verzerrung verhält. Dabei können beispielsweise auch Verzerrungen berücksichtigt werden, die durch weitere analoge Beschaltungen, wie z.B. das analoge Filter 9 oder einen eventuell nachgeschalteten Lautsprecher, generiert werden. Als Ergebnis ergeben sich verzerrungsfreie analoge Signale 18 und/oder 19.

## Patentansprüche

1. Digital/Analog-Umsetzer-Schaltung (1) zur Umsetzung eines digitalen PCM-Eingangssignals (11) in ein analoges Ausgangssignal (19), bei welcher im Signalweg in der nachfolgend genannten Reihenfolge angeordnet sind:
- eine Vorkompensationsstufe (10),
- eine PCM/PWM-Umsetzerstufe (7), und
- eine Digital/Analog-Umsetzerstufe (8),
wobei die Übertragungsfunktion der Vorkompensationsstufe (10) derart ausgelegt ist, dass das analoge Ausgangssignal (19) im Wesentlichen proportional zu dem digitalen PCM-Eingangssignal (11) ist,
**dadurch gekennzeichnet,**
**dass** die Vorkompensationsstufe (10) nachfolgend genannte Bauelemente, die im Signalweg in der genannten Reihenfolge angeordnet sind, umfasst:
- eine weitere PCM/PWM-Umsetzerstufe (3),
- eine Überabtaststufe (4),
- ein digitales Filter (5), und
- eine Dezimationsstufe (6).

2. Digital/Analog-Umsetzer-Schaltung (1) nach Anspruch 1,
**dadurch gekennzeichnet,**
- **dass** die Vorkompensationsstufe (10) derart ausgelegt ist, dass sie zumindest teilweise mit einer höheren Signalrate als der Signalrate des digitalen PCM-Eingangssignals (11) arbeitet.

3. Digital/Analog-Umsetzer-Schaltung (1) nach Anspruch 1 oder 2,
**dadurch gekennzeichnet,**
- **dass** die Übertragungsfunktion des digitalen Filters (5) derart einstellbar ist oder derart eingestellt ist, dass das analoge Ausgangssignal (19) im Wesentlichen proportional zu dem digitalen PCM-Eingangssignal (11) ist.

4. Digital/Analog-Umsetzer-Schaltung (1) nach einem oder mehren der vorhergehenden Ansprüche,
**dadurch gekennzeichnet,**
- **dass** die Übertragungsfunktion des digitalen Filters (5) als Tiefpass-Funktion ausgelegt ist.

5. Digital/Analog-Umsetzer-Schaltung (1) nach einem oder mehreren der vorhergehenden Ansprüche,
**dadurch gekennzeichnet,**
- **dass** der Vorkompensationsstufe (10) ein Noise-Shaper (2) vor- und/oder nachgeschaltet ist.

6. Digital/Analog-Umsetzer-Schaltung (1) nach einem oder mehreren der vorhergehenden Ansprüche,
**dadurch gekennzeichnet,**
- **dass** der Digital/Analog-Umsetzerstufe (8) ein analoges Filter (9) nachgeschaltet ist.

7. Digital/Analog-Umsetzer-Schaltung (1) nach einem oder mehreren der vorhergehenden Ansprüche,
**dadurch gekennzeichnet,**
- **dass** das digitale Filter (5) ein rekursives Wellen-Digital-Filter oder ein FIR-Filter ist.

8. Digital/Analog-Umsetzer-Schaltung (1) nach einem oder mehreren der vorhergehenden Ansprüche,
**dadurch gekennzeichnet,**
- **dass** die Digital/Analog-Umsetzerstufe (8) ein Leistungsschalter ist.

9. Digital/Analog-Umsetzer-Schaltung (1) nach einem oder mehreren der vorhergehenden Ansprüche, enthalten in einem Audioverstärker, insbesondere in einem Audio-Class-D-Verstärker.

10. Verfahren zur Umsetzung eines digitalen PCM-Eingangssignals (11) in ein analoges Ausgangssignal (19), mit den Schritten:
- Vorkompensation des digitalen PCM-Eingangssignals (11);
- Umsetzen des digitalen, vorkompensierten PCM-Signals (16) in ein digitales PWM-Signal (17); und
- Umsetzen des digitalen PWM-Signals (17) in das analoge Ausgangssignal (19),
wobei die Vorkompensation des digitalen PCM-Eingangssignals (11) bewirkt, dass das analoge Ausgangssignal (19) im Wesentlichen proportional zu dem digitalen PCM-Eingangssignal (11) ist,
**dadurch gekennzeichnet,**
- **dass** bei der Vorkompensation des digitalen PCM-Eingangssignals (11) folgende Schritte durchgeführt werden:
- Umsetzen des digitalen PCM-Eingangssignals (11) in ein digitales PWM-Zwischensignal (13);
- Erzeugen eines digitalen PCM-Zwischensignals (14) durch Überabtasten des digitalen PWM-Zwischensignals (13);
- Filtern des digitalen PCM-Zwischensignals (14) mittels eines digitalen Filters (5); und
- Reduzieren der Signalrate durch Reduzieren der Abtastwerte des gefilterten digitalen PCM-Zwischensignals (15) mittels einer Dezimationsstufe (6).

11. Verfahren nach Anspruch 10,
**dadurch gekennzeichnet,**
- **dass** die Vorkompensation des digitalen PCM-Eingangssignals (11) zumindest teilweise mit einer höheren Signalrate als der Signalrate des digitalen PCM-Eingangssignals (11) durchgeführt wird.

12. Verfahren nach Anspruch 10 oder 11,
**dadurch gekennzeichnet,**
- **dass** die Übertragungsfunktion des digitalen Filters (5) derart eingestellt wird oder derart eingestellt ist, dass das analoge Ausgangssignal (19) im Wesentlichen proportional zu dem digitalen PCM-Eingangssignal (11) ist.

13. Verfahren nach einem oder mehreren der vorhergehenden Ansprüche 10 bis 12,
**dadurch gekennzeichnet,**
- **dass** die Übertragungsfunktion des digitalen Filters (5) als Tiefpass-Funktion ausgelegt ist.

14. Verfahren nach einem oder mehreren der Ansprüche 10 bis 13,
**dadurch gekennzeichnet,**
- **dass** das digitale PCM-Eingangssignal (11) vor der Vorkompensation und/oder gegebenenfalls das von der Dezimationsstufe (6) ausgegebene digitale PCM-Signal von einem Noise-Shaper (2) verarbeitet wird.

15. Verfahren nach einem oder mehreren der Ansprüche 10 bis 14,
**dadurch gekennzeichnet,**
- **dass** das analoge Ausgangssignal (18) gefiltert wird.

16. Verfahren nach einem oder mehreren der Ansprüche 10 bis 15,
**dadurch gekennzeichnet,**
- **dass** das digitale Filter (5) ein rekursives Wellen-Digital-Filter oder ein FIR-Filter ist.

17. Verfahren nach einem oder mehreren der Ansprüche 10 bis 16,
**dadurch gekennzeichnet,**
- **dass** digitale PWM-Signal (17) mittels eines Leistungsschalters in das analoge Ausgangssignal (19) umgesetzt wird.

18. Verfahren nach einem oder mehreren der Ansprüche 10 bis 17, eingesetzt in einem Audioverstärker, insbesondere in einem Audio-Class-D-Verstärker.

## Claims

1. Digital/analogue converter circuit (1) for converting a digital PCM input signal (11) into an analogue output signal (19), in which the signal path contains the following in the stated order:
- a precompensation stage (10),
- a PCM/PWM converter stage (7), and
- digital/analogue converter stage (8),
where the transfer function of the precompensation stage (10) is designed such that the analogue output signal (19) is essentially proportional to the digital PCM input signal (11),
**characterized**
- **in that** the precompensation stage (10) comprises the following components, which are arranged in the signal path in the stated order:
- a further PCM/PWM converter stage (3),
- an oversampling stage (4),
- a digital filter (5), and
- a decimation stage (6).

2. Digital/analogue converter circuit (1) according to Claim 1,
**characterized**
- **in that** the precompensation stage (10) is designed such that it operates, at least to some extent, at a higher signal rate than the signal rate of the digital PCM input signal (11).

3. Digital/analogue converter circuit (1) according to Claim 1 or 2,
**characterized**
- **in that** the transfer function of the digital filter (5) can be set such or has been set such that the analogue output signal (19) is essentially proportional to the digital PCM input signal (11).

4. Digital/analogue converter circuit (1) according to one or more of the preceding claims,
**characterized**
- **in that** the transfer function of the digital filter (5) is designed as a low-pass filter function.

5. Digital/analogue converter circuit (1) according to one or more of the preceding claims,
**characterized**
- **in that** the precompensation stage (10) has a noise shaper (2) connected upstream/downstream of it.

6. Digital/analogue converter circuit (1) according to one or more of the preceding claims,
**characterized**
- **in that** the digital/analogue converter stage (8) has an analogue filter (9) connected downstream of it.

7. Digital/analogue converter circuit (1) according to one or more of the preceding claims,
**characterized**
- **in that** the digital filter (5) is a recursive wave digital filter or an FIR filter.

8. Digital/analogue converter circuit (1) according to one or more of the preceding claims,
**characterized**
- **in that** the digital/analogue converter stage (8) is a circuit breaker.

9. Digital/analogue converter circuit (1) according to one or more of the preceding claims, contained in an audio amplifier, particularly in an audio class D amplifier.

10. Method for converting a digital PCM input signal (11) into an analogue output signal (19), having the following steps:
- precompensation for the digital PCM input signal (11) ;
- conversion of the digital, precompensated PCM signal (16) into a digital PWM signal (17); and
- conversion of the digital PWM signal (17) into the analogue output signal (19);
where precompensating for the digital PCM input signal (11) causes the analogue output signal (19) to be essentially proportional to the digital PCM input signal (11),
**characterized**
- **in that** the precompensation for the digital PCM input signal (11) involves carrying out the following steps:
- conversion of the digital PCM input signal (11) into a digital PWM intermediate signal (13);
- generation of a digital PCM intermediate signal (14) by oversampling the digital PWM intermediate signal (13) ;
- filtering of the digital PCM intermediate signal (14) using a digital filter (5); and
- reduction of the signal rate by reducing the sampled values of the filtered digital PCM intermediate signal (15) using a decimation stage (6).

11. Method according to Claim 10,
**characterized**
- **in that** the precompensation for the digital PCM input signal (11) is performed, at least to some extent, at a higher signal rate than the signal rate of the digital PCM input signal (11).

12. Method according to Claim 10 or 11,
**characterized**
- **in that** the transfer function of the digital filter (5) is set such or has been set such that the analogue output signal (19) is essentially proportional to the digital PCM input signal (11).

13. Method according to one or more of the preceding claims,
**characterized**
- **in that** the transfer function of the digital filter (5) is designed as a low-pass filter function.

14. Method according to one or more of Claims 10 to 13,
**characterized**
- **in that** the digital PCM input signal (11) prior to precompensation and/or, if appropriate, the digital PCM signal which is output by the decimation stage (6) is processed by a noise shaper (2).

15. Method according to one or more of Claims 10 to 14,
**characterized**
- **in that** the analogue output signal (18) is filtered.

16. Method according to one or more of Claims 10 to 15,
**characterized**
- **in that** the digital filter (5) is a recursive wave digital filter or an FIR filter.

17. Method according to one or more of Claims 10 to 16,
**characterized**
- **in that** the digital PWM signal (17) is converted into the analogue output signal (19) using a circuit breaker.

18. Method according to one or more of Claims 10 to 17, used in an audio amplifier, particularly in an audio class D amplifier.

## Revendications

1. Circuit (1) de convertisseur numérique/analogique pour convertir un signal (11) d'entrée PCM numérique en un signal (19) de sortie analogique, dans lequel il est disposé dans le trajet du signal, dans l'ordre de succession mentionné suivant :
- un étage (10) de précompensation,
- un étage (7) de convertisseur PCM/PWM, et
- un étage (8) de convertisseur numérique/analogique,
la fonction de transfert de l'étage (10) de précompensation étant telle que le signal (19) de sortie analogique est sensiblement proportionnel au signal (11) d'entrée PCM numérique,
**caractérisé**
**en ce que** l'étage (10) de précompensation comprend les composants mentionnés suivants, qui sont disposés dans le trajet de signal dans l'ordre de succession mentionné :
- un autre étage (3) de convertisseur PCM/PWM,
- un étage (4) de suréchantillonnage,
- un filtre (5) numérique, et
- un étage (6) de décimation.

2. Circuit (1) de convertisseur numérique/analogique suivant la revendication 1,
**caractérisé**
- **en ce que** l'étage (10) de précompensation est tel qu'il opère, au moins en partie, à un débit de signal plus grand que le débit du signal (11) d'entrée PCM numérique.

3. Circuit (1) de convertisseur numérique/analogique suivant la revendication 1 ou 2,
**caractérisé**
- **en ce que** la fonction de transfert du filtre (5) numérique est réglée ou peut être réglée de façon à ce que le signal (19) de sortie analogique soit sensiblement proportionnel au signal (11) d'entrée PCM numérique.

4. Circuit (1) de convertisseur numérique/analogique suivant l'une ou plusieurs des revendications précédentes,
**caractérisé**
- **en ce que** la fonction de transfert du filtre (5) numérique est conçu comme une fonction passe-bas.

5. Circuit (1) de convertisseur numérique/analogique suivant l'une ou plusieurs des revendications précédentes,
**caractérisé**
- **en ce qu'**il est monté un Noise-Shaper (2) en amont et/ou en aval de l'étage (10) de précompensation.

6. Circuit (1) de convertisseur numérique/analogique suivant l'une ou plusieurs des revendications précédentes,
**caractérisé**
- **en ce que** un filtre (9) analogique est monté en aval de l'étage (8) de convertisseur numérique/analogique.

7. Circuit (1) de convertisseur numérique/analogique suivant l'une ou plusieurs des revendications précédentes,
**caractérisé**
- **en ce que** le filtre (5) numérique est un filtre numérique de mode récursif ou un filtre FIR.

8. Circuit (1) de convertisseur numérique/analogique suivant l'une ou plusieurs des revendications précédentes,
**caractérisé**
- **en ce que** l'étage (8) de convertisseur numérique/analogique est un commutateur de puissance.

9. Circuit (1) de convertisseur numérique/analogique suivant l'une ou plusieurs des revendications précédentes, contenu dans un amplificateur audio, notamment dans un amplificateur audio de Classe D.

10. Procédé de conversion d'un signal (11) d'entrée PCM numérique en un signal (19) de sortie analogique, comprenant les stades de :
- précompensation du signal (11) d'entrée PCM numérique ;
- conversion du signal (16) PCM numérique précompensé en un signal (17) PWM numérique ; et
- conversion du signal (17) PWM numérique en le signal (19) de sortie analogique,
dans lequel la précompensation du signal (11) d'entrée PCM numérique fait que le signal (19) de sortie analogique est sensiblement proportionnel au signal (11) d'entrée PCM numérique,
**caractérisé**
- **en ce que** lors de la précompensation du signal (11) d'entrée PCM numérique on effectue les stades suivants :
- conversion du signal (11) d'entrée PCM numérique en un signal (13) intermédiaire PWM numérique ;
- production d'un signal (14) intermédiaire PCM numérique par suréchantillonnage du signal (13) intermédiaire PWM numérique ;
- filtrage du signal (14) intermédiaire PCM numérique au moyen d'un filtre (5) numérique ; et
- réduction du débit du signal par réduction des valeurs d'échantillonnage du signal (15) intermédiaire PCM numérique filtré au moyen d'un étage (6) de décimation.

11. Procédé suivant la revendication 10,
**caractérisé**
- **en ce que** l'on effectue la précompensation du signal (11) d'entrée PCM numérique au moins en partie à un débit de signal plus grand que le débit du signal (11) d'entrée PCM numérique.

12. Procédé suivant la revendication 10 ou 11,
**caractérisé**
- **en ce que** l'on règle la fonction de transfert du filtre (15) numérique ou elle est telle que le signal (19) de sortie analogique est sensiblement proportionnel au signal (11) d'entrée PCM numérique.

13. Procédé suivant l'une ou plusieurs des revendications précédentes 10 à 12,
**caractérisé**
- **en ce que** la fonction de transfert du filtre (5) numérique est conçue sous la forme d'une fonction passe-bas.

14. Procédé suivant l'une ou plusieurs des revendications 10 à 13,
**caractérisé**
- **en ce que** l'on traite le signal (11) d'entrée PCM numérique avant la précompensation et/ou, le cas échéant, le signal PCM numérique émis par l'étage (6) de décimation par un Noise-Shaper (2).

15. Procédé suivant l'une ou plusieurs des revendications précédentes 10 à 14,
**caractérisé**
- **en ce que** l'on filtre le signal (18) de sortie analogique.

16. Procédé suivant l'une ou plusieurs des revendications précédentes 10 à 15,
**caractérisé**
- **en ce que** le filtre (5) numérique est un filtre numérique de mode récursif ou un filtre FIR.

17. Procédé suivant l'une ou plusieurs des revendications précédentes 10 à 16,
**caractérisé**
- **en ce que** l'on convertit le signal (17) PWM numérique en le signal (19) de sortie analogique au moyen d'un commutateur de puissance.

18. Procédé suivant l'une ou plusieurs des revendications précédentes 10 à 17, utilisé dans un amplificateur audio, notamment dans un amplificateur audio de Classe D.
